# EUROPÄISCHE PATENTSCHRIFT

(11) **EP 2 276 871 B1**
(45) Veröffentlichungstag und Bekanntmachung des Hinweises auf die Patenterteilung: **18.12.2013**
(21) Anmeldenummer: 09728119.0
(22) Anmeldetag: 14.03.2009
(51) Int. Cl.: C23C 16/30, C23C 16/455

(54) **VERFAHREN ZUR HERSTELLUNG EINER N-HALBLEITENDEN INDIUMSULFID-DÜNNSCHICHT**
METHOD FOR PRODUCING AN N-SEMICONDUCTIVE INDIUM SULFIDE THIN LAYER
PROCÉDÉ POUR PRODUIRE UNE COUCHE MINCE DE SULFURE D'INDIUM SEMICONDUCTRICE N

(30) Priorität: 01.04.2008 DE 102008017077
(43) Veröffentlichungstag der Anmeldung: 26.01.2011
(73) Patentinhaber: Helmholtz-Zentrum Berlin für Materialien und Energie GmbH, 14109 Berlin (DE)
(72) Erfinder: ALLSOP, Nicholas, 10243 Berlin (DE); FISCHER, Christian-Herbert, 14169 Berlin (DE); GLEDHILL, Sophie, 10551 Berlin (DE); LUX-STEINER, Martha Christina, 14163 Berlin (DE)
(86) Internationale Anmeldenummer: PCT/DE2009/000353
(87) Internationale Veröffentlichungsnummer: WO 2009/121318

(56) Entgegenhaltungen:
- EP-A- 1 717 343
- US-A- 5 480 818
- US-A1- 2002 172 768
- US-A1- 2005 287 775
- ALLSOP ET AL: "Indium sulfide thin films deposited by the spray ion layer gas reaction technique" THIN SOLID FILMS, ELSEVIER-SEQUOIA S.A. LAUSANNE, CH, Bd. 513, Nr. 1-2, 14. August 2006 (2006-08-14), Seiten 52-56, XP005517604 ISSN: 0040-6090 in der Anmeldung erwähnt
- SATOSHI TANIMOTO ET AL: "SYNCHRONOUSLY EXCITED DISCRETE CHEMICAL VAPOR DEPOSITION OF TA2O5" JOURNAL OF THE ELECTROCHEMICAL SOCIETY, ELECTROCHEMICAL SOCIETY. MANCHESTER, NEW HAMPSHIRE, US, Bd. 141, Nr. 5, 1. Mai 1994 (1994-05-01), Seiten 1339-1346, XP000470155 ISSN: 0013-4651

## Beschreibung

Die Erfindung betrifft ein Verfahren zur Herstellung einer n-halbleitenden Indiumsulfid-Dünnschicht (In₂S₃) auf einem beheizten Substrat mit einem Zweiquellen-Precursor aus einem Indium enthaltenden Precursor (PR_{in(g/fl)}) und Schwefelwasserstoff (H₂S) als reaktivem, gasförmigem Precursor und einem inerten Trägergasstrom bei Atmosphärendruck.

N-halbleitende Metallsulfid-Dünnschichten werden als Pufferschichten in Solarzellen zwischen Absorber- und Fensterschicht eingesetzt, wodurch sich eine deutliche Erhöhung des Wirkungsgrades erzielen lässt. Unter einer Pufferschicht ist eine Schicht mit höherer Bandlücke als die angrenzende halbleitende Absorberschicht zu verstehen. Die höhere Bandlücke kann dabei durch Legieren oder durch eine entsprechende Materialwahl erreicht werden. Durch bessere Grenzflächenzustände und bessere Bandanpassung wird die Rekombination im Grenzflächenbereich des pn-Übergangs verringert und dadurch die offene Klemmenspannung erhöht. Das CdS ist ein n-Typ Halbleiter und besitzt eine Bandlücke von 2,4 eV und absorbiert somit im UV-und sichtbaren Bereich des Sonnenspektrums. Die dabei generierten Elektron-Loch-Paare werden nicht über die Raumladungszone getrennt und tragen somit nicht zum Strom bei. Die Funktion der Pufferschicht ist vielfältig und noch nicht in allen Einzelheiten eindeutig geklärt. Diese Schicht schützt die Absorberschicht vor Schäden und chemischen Reaktionen bei der Deposition der transparenten Kontäktschicht, beispielsweise ZnO-Schicht. Zunehmend wird versucht, die toxische CdS-Schicht durch weniger toxische Materialien zu ersetzen. Dabei wird auch zunehmend das CVD-Verfahren in verschiedenen Varianten eingesetzt, was ebenfalls eine gute Abdeckung rauer Substrate ermöglicht. Insbesondere Indium(III)sulfid (In₂S₃) mit einer indirekten Bandlücke von 2 eV bis 2,2 eV hat sehr gute Aussichten, das toxische CdS abzulösen, weshalb verschiedenste Herstellungsmöglichkeiten aus dem Stand der Technik bekannt sind. Eine Herstellung mit einem CVD-Verfahren ist aber bislang nicht bekannt, da die einzusetzenden Komponenten nach Kenntnis des Fachmannes dazu neigen, bereits in der Gasphase feste Reaktionsprodukte zu bilden, die dann zu inhomogenen Schichten mit einer schlechten Abdeckung auf dem Substrat führen.

### STAND DER TECHNIK

Es sind vor allem zwei sequenzielle Verfahren zur Herstellung von Indiumsulfid-Dünnschichten bekannt. Dabei handelt es sich um das ALCVD-Verfahren (Atomic Layer Chemical Vapor Deposition oder auch Atomic Layer Epitaxy ALE oder auch ALD Atomic Layer Deposition) und das ILGAR-Verfahren (Ion Layer Gas Reaction). Bei der ALCVD werden im Vakuum einzelne Atomlagen eines Precursormaterials auf ein Substrat aufgebracht (adsorbiert) und dann mit dem zweiten Precursor zur Reaktion gebracht. Es entstehen geordnete, gestapelte (epitaktische) Molekülschichten, die die Herstellung dünnster ("monomolekularer") Indium-Sulfidschichten erlauben. Durch zyklisches Wiederholen kann Atomschicht auf Atomschicht gelagert werden. Aufgrund dieser Prozessführung ist das Verfahren naturgemäß sehr langsam und für eine industrielle Produktion von einigen 10 nm dicken Schichten kaum geeignet. Außerdem können nicht in Reaktion gekommene Atome des ersten Precursors unterer Schichten nachträglich nicht mehr zur Reaktion gebracht werden und somit Fehlstellen bilden. Eine vollständige Durchreaktion ungeordneter Schichten aus dem ersten Precursormaterial ist beim ILGAR-Verfahren hingegen sehr gut möglich. Beim ILGAR-Verfahren wird das erste Precursormaterial vollständig in einem Lösungsmittel gelöst, sodass eine homogene flüssige Phase entsteht und durch Sprühen oder Tauchen auf das Substrat aufgebracht, sodass die Ionen des ersten Precursor-materials ungeordnet an der Substratoberfläche gleichmäßig adsorbiert werden. Dann wird im Falle des Tauchens das Lösungsmittel bzw. Reste davon durch Trocknung oder Verdunstung entfernt, sodass der dünne feste Precursorfilm gut zugänglich ist für den gasförmigen zweiten Precursor, der im nächsten Schritt zugeführt wird. Es wird eine gute Durchreaktion der gesamten Schicht erreicht, die genau der Oberflächenmorphologie des Substrats folgt, sodass auch poröse Substrate gut bedeckt werden. Eingestellt werden kann die Schichtdicke durch zyklisches Wiederholen dieser Verfahrensschritte, dabei sind die optischen Schichteigenschaften beeinflussbar. Bei der Schichtherstellung wird im Stand der Technik jedoch besonders darauf geachtet, dass sich die beiden Precursor im Verfahren nicht miteinander in Kontakt kommen, da es ansonsten in der Gasphase zu einer vorzeitigen Reaktion, d.h. Pulverbildung kommen kann, die zu schlechter Schichthaftung und Homogenität und damit zu qualitativ schlechteren Schichten führen würde. Deshalb wird zwischen den sequenziellen Verfahrensschritten gründlich mit einem Inertgas gespült.

ALCVD zur Herstellung von In₂S₃-Schichten ist beispielsweise aus **ASIKAINEN 1994** bekannt. Dabei werden bei 275°C aus der Festphase verdampftes und an der auf 300°C bis 400°C aufgeheizten Substratoberfläche adsorbiertes InCl₃ und sowie H₂S-Gas eingesetzt. Aus **NAGHAVI 2003** ist ein ALCVD-Verfahren für Pufferschichten von Solarzellen bekannt, bei dem bei 125°C verdampftes Indiumacetylacetonat In(acac)₃ und H₂S-Gas bei Substrattemperaturen von 160°C bis 260°C eingesetzt werden. Für den Fachmann ist es jedoch allgemein bekannt, dass ein derartiges Verfahren viel zu langsam und zu teuer für eine Industrieproduktion von Solarzellen ist.

Aus der WO 93/04212 A1 ist es bekannt, möglichst gut orientierte kristalline Dünnschichten aus Verbindungen der Gruppe III- und der Gruppe VI-Elemente in einem trägergasgestützten einphasigen Verdampfungsprozess (singlesource-CVD) herzustellen. Dabei sind jedoch Substrattemperaturen zwischen 350°C und 650°C erforderlich, um die als Precursor eingesetzten Metallorganyle, die zunächst aufwändig und teuer aus Metallhalogeniden o.ä. hergestellt werden müssen, aufzuspalten. Dem Trägergas kann zwar bei der Herstellung von Indiumsulfid-Schichten Schwefelwasserstoff zugesetzt werden, eine Aussage, in welchen Mengen dies erfolgen soll, wird aber nicht gegeben. Vielmehr wird in den Ausführungsbeispielen mit ausschließlich Argon-Trägergas eine Schwefelwasserstoffzugabe nicht weiter erwähnt. Aus der US 5.112.650 ist es auf dem Gebiet der CVD für Metallchalkogenid-Dünnschichten dazu bekannt, dass eine Schwefelwasserstoffzugabe in das Trägergas in der Theorie zwar möglich, in der Praxis im Falle unlöslicher Metallsulfide nicht brauchbar ist, da es zu unerwünschter Pulverbildung und damit zu inhomogener Schichtbildung führt.

Das ILGAR-Verfahren arbeitet energiefreundlich bei Umgebungs-/Atmosphärendruck und einer Temperatur, die von dem Ionenaustauschverhalten der eingesetzten Materialien abhängig ist (typischerweise Umgebungs-/Raumtemperatur) und ist grundsätzlich aus der DE 198 31 214 C2 (Modifikation: ILGAR-Sulfidbildung über Hydroxid-Zwischenstufe DE 199 16 403 C1) bekannt. Die Inhalte der genannten Druckschriften sollen durch ihr Zitat ausdrücklich als zum Offenbarungsgehalt der vorliegenden Erfindung zugehörig angesehen werden.

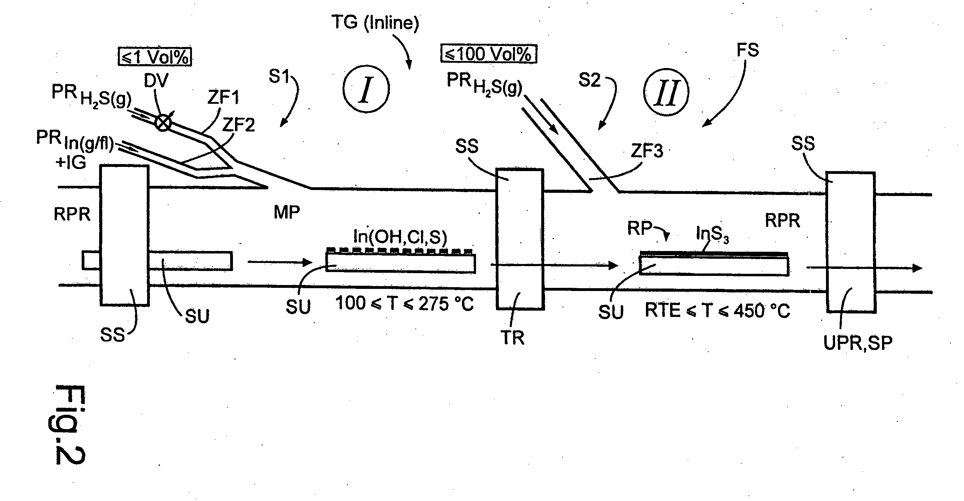

Der nächstliegende Stand der Technik, von dem die vorliegende Erfindung ausgeht, wird in **ALLSOP 2005** (Zellparameter) und **ALLSOP 2006** (Experimental) offenbart. Es wird das ILGAR-Verfahren mit einem Aufsprühen des gelösten Precursors (Spray-ILGAR) zur Herstellung von In₂S₃- Pufferschichten für den Einsatz in Chalkopyrit-Solarzellen beschrieben. Nach dem zuvor allgemein erläuterten ILGAR-Verfahrensablauf mit den grundsätzlich voneinander getrennten Verfahrensschritten (sequenzielles Verfahren) wird zunächst Indiumchlorid (InCl₃) in Ethanol gelöst und dann mit einem Ultraschallgenerator zu einem Sprühnebel (Aerosol = Gemisch aus flüssigen Schwebeteilchen und Luft) vernebelt. Dieser Sprühnebel wird mithilfe eines inerten Stickstoffgasstroms (N₂) bis zum geheizten Substrat transportiert. Das Substrat hat für eine gute Depositionsrate eine Temperatur zwischen 300°C und 450°C (vergleiche ALLSOP **2006,** Figur 2). Grundsätzlich tritt aber eine gute Schichtbildung bereits ab 100°C auf. Insbesondere bei einem Aufwuchs einer Pufferschicht auf einer Absorberschicht ist darauf zu achten, dass diese nicht beschädigt wird und die Heiztemperatur auf deutlich unter 300° gefahren wird, typischerweise zwischen 175 und 250°C. Die an der Substratoberfläche abgeschiedenen Indium-Ionen werden dann mit Schwefelwasserstoffgas behandelt, sodass auf der Substratoberfläche die gewünschte Reaktion zu In₂S₃ stattfindet. Zwischen den einzelnen Verfahrensschritten wird außerdem immer wieder mit N₂ gespült, um einen Kontakt der beiden Precursor in der Gasphase zu verhindern.

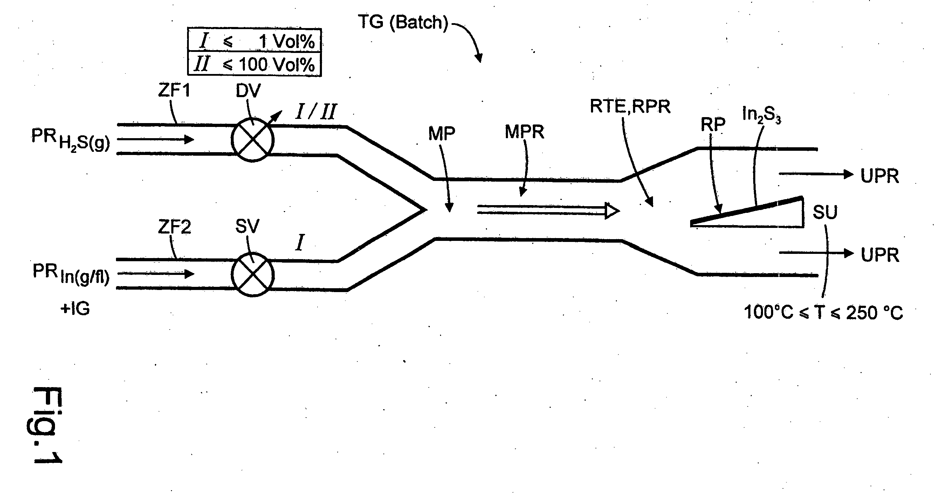

Der prinzipielle Aufbau einer geeigneten Anordnung zur Durchführung des zuvor beschriebenen Verfahrens ist der Figur 1 aus **ALLSOP 2006** zu entnehmen. Das dort gezeigte Ventil in der Zuführung von Schwefelwasserstoff ist ein Sperrventil. Dieses Ventil wird nur im zweiten sequenziellen Verfahrensschritt geöffnet. Dann ist der erste sequenzielle Verfahrensschritt abgeschlossen und der Ultraschallgenerator abgestellt, sodass kein Sprühnebel (Aerosol) mehr erzeugt wird. Außerdem wurde mit N₂ gespült, sodass sich kein Material des ersten Precursors mehr im Reaktionsgefäß befindet. Dieses Sperrventil dient somit zur Einhaltung des konsequent sequenziellen Verfahrensablaufs und kennt nur die Zustände "offen" oder "geschlossen".

### AUFGABENSTELLUNG

Der Erfindung liegt die Aufgabe zugrunde, das zuvor beschriebene gattungsgemäße Verfahren ("Sprüh-ILGAR") zur Erzeugung von Indiumsulfid-Dünnschichten (In₂S₃) auf einem beheizten Substrat mit einem sprühfähigen, Indium enthaltenden Precursor und Schwefelwasserstoff als reaktivem, gasförmigem Precursor so weiterzubilden, dass besonders homogene und kompakte Indium-Sulfidschichten in gleich bleibender Qualität unter Beachtung ökonomischer und ökologischer Gesichtspunkte bei einer gleichzeitig noch verbesserten Materialausnutzung und Depositionsrate hergestellt werden können. Die erfindungsgemäße Lösung für diese Aufgabe ist dem Verfahrensanspruch zu entnehmen. Vorteilhafte Weiterbildungen sind den Unteransprüchen zu entnehmen und werden im Nachfolgenden im Zusammenhang mit der Erfindung näher erläutert.

Bei dem erfindungsgemäßen Verfahren wird das bekannte Sprüh-ILGAR-Verfahren unter Erhaltung seiner, in den oben zitierten Druckschriften genannten Vorteile um einen CVD-Verfahrensschritt, genauer APCVD atmospheric Pressure Chemical Vapor Deposition, CVD bei Atmosphärendruck, erweitert und in ein Verfahren überführt, bei dem sequenziell zwei Verfahrensphasen ablaufen, wobei in der ersten Verfahrensphase ein Simultanprozess durchgeführt wird. Dabei arbeitet das erfindungsgemäße Verfahren aber immer noch durchgängig bei Atmosphärendruck, was für die Anwendung eines CVD-Verfahrens ungewöhnlich ist, da die eingesetzten Komponenten einen entsprechend hohen Dampfdruck (Siedepunkt) aufweisen müssen. Nach wie vor wird eine lonenaustausch-Reaktion herbeigeführt, nunmehr aber nicht mehr ausschließlich auf der Substratoberfläche, sondern es findet auch eine teilweise Sulfurisierung bereits in der Gasphase hinter dem Mischpunkt statt. Aufgrund der gewählten Parameterwerte findet beim CVD-Schritt aber keine Pulverbildung im Reaktionsgefäß statt, das Raumtemperatur, gewöhnlich aber eine Temperatur unterhalb der Substrattemperatur aufweist, sodass eine Verschlechterung der erzeugten Indiumsulfid-Dünnschicht durch Pulverbildung sicher vermieden ist. Positiver Effekt des simultanen CVD-Schritts während der ersten Verfahrensphase ist damit eine weitere Verbesserung der Kompaktheit und Homogenität der erzeugten Indiumsulfid-Dünnschicht bei einer gleichzeitig verbesserten Materialausnutzung und Erhöhung der Depositionsrate. Eine laminare Gasströmung über das Substrat in der ersten Verfahrensphase kann dabei die Qualität der erzeugten Schicht noch verbessern. Durch ein schnelleres Schichtenwachstum können bei der Produktion kürzere Taktzeiten und damit ein größerer Durchsatz erreicht werden. Im Falle einer In-line-Prozessführung können hierdurch Zyklen und damit die Anzahl hintereinandergeschalteter Depositionseinheiten eingespart werden. Im Vergleich zu einem reinen CVD-Prozess können kompaktere Schichten mit einem geringeren Rest-Halogenidgehalt, speziell Chlorgehalt, hergestellt werden.

Für das Verfahren nach der Erfindung wird ein Indium enthaltender Precursor ausgewählt, der entweder selbst einen hohen Dampfdruck besitzt oder mit einem geeigneten Lösungsmittel ein flüchtiges Addukt bildet. Dieser wird zunächst gelöst und in ein Aerosol oder die Gasphase überführt. Anschließend wird jeweils unter Beteiligung des Trägergasstroms der gelöste Precursor als Aerosol auf das auf eine Temperatur gleich oder zwischen 100°C bis 275°C geheizte Substrat aufgesprüht oder der gasförmige Precursor auf das auf eine Temperatur gleich oder zwischen 100°C bis 275°C geheizte Substrat geleitet (ggfs. laminare Überströmung), sodass auf dessen Oberfläche die homogen feste Indiumverbindungen abgeschieden werden. Gleichzeitig wird in dieser Verfahrensphase eine solche Menge von Schwefelwasserstoff dem gelösten und als Aerosol versprühten oder gasförmigen Indium enthaltenden Precursor zugeführt, dass sich eine absolute Konzentration des Schwefelwasserstoffs gleich oder weniger als 1 Vol% im Mischgebiet ergibt. In Relation dazu wird die Indium-Konzentration des Indium enthaltenden Precursors (PR_{In(g/fl)}) so gewählt, dass sich eine kompakte In(OHₓ,X_{y},S_{z})₃-Schicht mit X=Halogenid und x+y+2z=1 mit z≠0 ausbildet.

Substrattemperatur und absolute Konzentration des Schwefelwasserstoffgases sind die relevanten Parameter zur Vermeidung von unerwünschter Pulverbildung im Reaktionsgefäß und nicht kompakter Schichten. Die richtige Einstellung dieser beiden Verfahrensparameter gewährleistet, dass bei dem Verfahren nach der Erfindung eine Reaktion zum Indiumsulfid nur auf oder unmittelbar oberhalb des geheizten Substrats erfolgt, sodass sich das feste Indiumsulfid in homogener und kompakter Weise ausschließlich auf der Substratoberfläche bildet. Trotzdem kann bereits hinter dem Mischpunkt eine Reaktion zwischen Schwefelwasserstoffgas einerseits und Aerosoltröpfchen bzw. gasförmiger Indium-Verbindung (s.u.) stattfinden. Während der direkten Ablagerung der festen Verbindung aus dem Indium enthaltenden Precursor auf der beheizten Substratoberfläche (Verfahrensphase I) reagiert ein sehr viel kleinerer Anteil aus dem Indium enthaltenden Precursor mit dem Schwefel aus dem Schwefelwasserstoffgas direkt vor oder auf der Oberfläche des beheizten Substrats. Zusätzlich zu der direkten Ablagerung des Indium enthaltenden Precursors wird somit noch eine Schicht aus noch reaktionsfähigen Indium-Ionen in Verbindungen In(OH,X(Cl),S) (dabei bedeutet die Schriftweise X(Cl), dass das Halogenid Chlor bevorzugt eingesetzt wird) auf dem Substrat abgelagert. Dabei erfolgt jegliche Ablagerung in homogener Form, da aufgrund der moderaten Temperaturwahl eine Reaktion im Reaktionsgefäß vermieden ist. Durch den simultanen CVD-Schritt kann eine bessere Materialausbeute bei einem schnelleren Schichtenwachstum erreicht werden.

Nach der Verfahrensphase I nach der Erfindung mit einer simultanen direkten Deposition des Indium enthaltenden Precursors (in großem Maße) und einem Reagieren beider Precursor und Deposition der Reaktionsprodukte (in geringerem Maße) auf dem Substrat läuft das anschließende Verfahren ohne weitere Veränderung gegenüber dem bekannten Sprüh-ILGAR-Verfahren ab. Anschließend wird die Verfahrensphase II, die sequenziell auf die erste folgt, zur Ionenaustausch-Reaktion der auf der Substratoberfläche adsorbierten Indiumverbindungen durch Einspeisung von Schwefelwasserstoff auf das beheizte Substrat durchgeführt. Dabei erfolgt aber keine reduzierende Dosierung des Schwefelwasserstoffs mehr, vielmehr kann Schwefelwasserstoff in der für die Ionenaustausch-Reaktion maximal möglichen Menge zugeführt werden. Da in der Verfahrensphase II kein Indium enthaltender Precursor als Gas oder Aerosol im Reaktionsgefäß mehr vorhanden ist, kann die Substrattemperatur höher gefahren werden, ohne dass eine Gefahr der Pulverbildung oder Abscheidung an den Gefäßwänden wie beim simultanen CVD-Schritt besteht. Das Substrat kann auf eine Temperatur gleich oder zwischen Raumtemperatur und 450°C gehalten bzw. geheizt werden, um Depositionsrate zu erhöhen. Allerdings ist die zulässige Erwärmung des Substrats zu berücksichtigen. Eine stärkere Erhitzung in der Verfahrensphase ii als in der Verfahrensphase I ist aber nur sinnvoll, wenn das Substrat bei der Beschichtung verschiedene, thermisch voneinander getrennte Stationen durchläuft und jeweils einfach unterschiedlich geheizt werden kann ("Inline-Fertigung"). Bei einer "Batch-Fertigung" mit einem ortsfesten Substrat würde das Fahren von Temperaturzyklen mit Heizen und Kühlen einen stark erhöhten Aufwand bedeuten, sodass hier das Substrat konstant auf einer Temperatur bis 275°C gehalten wird, die in beiden Verfahrensphasen I, II eingestellt wird und zu befriedigenden Ergebnissen führt. Alle Verfahrensschritte können bis zum Erreichen einer gewünschten Schichtdicke zyklisch wiederholt werden. Die erreichbaren Schichtdicken liegen in einem Variationsbereich von monomolekular bis zum µm-Bereich.

Zur Durchführung des Verfahrens nach der Erfindung wird ein Indium enthaltender Precursor, der entweder selbst einen hohen Dampfdruck besitzt oder mit einem geeigneten Lösungsmittel ein flüchtiges Addukt bildet, ausgewählt und zunächst in eine gelöste oder gasförmige Phase überführt. Im Reaktionsgefäß wird dann in der Verfahrensphase II der gelöste (Aerosol) oder gasförmige, Indium enthaltende Precursor einerseits direkt auf das beheizte Substrat geleitet, andererseits aber auch gleichzeitig mit Schwefelwasserstoffgas und dem inerten Trägergasstrom gemischt. Es ergibt sich - je nach Aggregatzustand des Precursors - ein Mischungspunkt flüssig/gasförmig oder gasförmig/gasförmig. Bei der Mischung eines Indium enthaltenden Precursors in Aerosolform mit dem gasförmigen kann vorteilhaft der Indium enthaltende Precursor in die gelöste Phase durch Auflösen in einem Lösungsmittel überführt werden. Es kann dann eine Zerstäubung der Lösung mit einem Ultraschallgenerator oder einem pneumatischen Zerstäuber zur Erzeugung eines Sprays aus feinsten Tropfen (Aerosol) erfolgen. Alternativ kann der Indium enthaltende Precursor auch in eine gasförmige Phase überführt werden. Bevorzugt kann diese durch Verdampfen des Aerosols oder durch Überleiten eines Lösungsmitteldampfes über den Indium enthaltenden festen Precursor erfolgen. Beispielsweise werden Ethanoldämpfe durch Blubbern von Inertgas, beispielsweise N₂, durch Ethanol erzeugt und dann über festes InCl₃ geleitet. Dabei bildet sich ein flüchtiges InCl₃-Ethanol-Addukt, das sich ohne Zugabe von H₂S auf dem Substrat zu InCl₃ bzw. in Abhängigkeit von der Temperatur auch zu In(X(Cl), O, OH) zersetzt und abscheidet. Die Reaktion mit H₂S während der Sprühphase führt zu In(OH,X(Cl),S) Schichten, die in der Verfahrensphase II zu In₂S₃ umgewandelt werden. Alternativ kann die Überführung in die gasförmige Phase auch durch Lösung in einem Lösungsmittel und Auftropfen der Lösung auf eine erwärmte Fläche erfolgen. Über die erwärmte Fläche strömt dann das Inertgas und leitet - wie vorher - den flüchtigen Precursor auf das beheizte Substrat.

Weiterhin kann es sich bevorzugt bei dem Indium enthaltenden Precursor um ein Halogenidsalz des Indiums handeln. Zu den Halogeniden X (oder Halogenen) zählen F, Cl, Br und I. Bevorzugt kann es sich bei dem Halogenidsalz um ein Salz des Indiumchlorids (InCl₃) handeln. Alternativ kann der Indium enthaltende Precursor auch ein β-Diketonat, bevorzugt Indium-Acetylacetonat (In(acac)₃), sein. Weiterhin kann allgemein das Lösungsmittel ein Alkohol, bevorzugt Ethanol, oder ein Keton, bevorzugt Aceton, sein. Schließlich wird bevorzugt ein Stickstoff Trägerstrom (N₂) eingesetzt.

Einer der größten Vorteile des Verfahrens nach der Erfindung ist sein vollständiger Ablauf bei Atmosphärendruck (Umgebungsdruck). Dadurch sind keine abgeschlossenen Reaktionsgefäße und Vakuumpumpen erforderlich. Durchlaufsysteme (Inline) können in einfacher Weise realisiert werden. Analog zum Umgebungsdruck herrscht bevorzugt in Reaktionsgefäß auch Umgebungstemperatur (Raumtemperatur). Die hauptsächliche Energieeinspeisung für die Reaktion zum Indiumsulfid erfolgt durch die Erhitzung des Substrats, sodass die entsprechende chemische Reaktion direkt auf der Oberfläche des Substrats oder unmittelbar davor eintritt. Die folgenden chemischen Bruttoreaktionen laufen je nach o.g. Materialien ab (g = gasförmig, fl = flüssig, f = fest):
2 InCl_{3(g/fl)} + 3 H₂S_{(g)} ⇒ In₂S_{3(f)} + 6 HCL_{(g)} oder
2 In(acac)_{3(g/fl)} + 3 H₂S_{(g)} ⇒ In₂S_{3(f)} + 6 Hacac_{(g)}

Dabei können noch folgende Zwischenschritte (Indium ist dreiwertig und kann unterschiedlich wertige Verbindungen eingehen) ablaufen und entsprechende Zwischenprodukte auftreten:

| Verfahrensphase I | |
|---|---|
| 1. 2 InCl_{3(g/fl)} + EtOH | → InₓX_{y} (X=Halogenid) |
| 2. InₓX_{y} + H₂S | → InₓZ_{z} (Z enthält S) |
| 3. InₓZ_{z} + InₓX_{y} + Wärme | → In(OH,X(Cl),S)_{(f)} |
| | |

| Verfahrensphase II | |
|---|---|
| In(OH,X(Cl),S)_{(f)} + H₂S | → In₂S₃(f) |

Eine moderate Vorheizung der Mischung aus dem Schwefelwasserstoff (H₂S) und dem Trägergasstrom beschleunigt die Reaktion und damit die Abscheide- bzw. Wachstumsrate.

Bei dem Verfahren nach der Erfindung ist bei einem vorgegebenen Substrat, beispielsweise einer Absorberschicht, die Heiztemperatur jedoch so zu wählen, dass keine Beeinträchtigung oder Zerstörung eintritt. Kann das Substrat frei gewählt werden, kann die Heiztemperatur vorgegeben werden und dann das Substrat entsprechend ausgewählt werden. Als Substrate können somit beispielsweise TiO₂, CulnS₂, CuGaSe₂, Chalkopyrite allgemein, Kunststoff, Metalle oder Glas eingesetzt werden.

Zur Kontrolle der wesentlichen Parameter während der ersten Verfahrensphase beim simultanen CVD-Schritt können in-situ Messungen vorgenommen werden. Neben einer kontinuierlichen Temperaturmessung und -regelung von Substrat und Precursor können vorteilhaft noch in-situ optische Messungen von eingesetzten Aerosolen zur Konzentrationsbestimmung durchgeführt werden. Dadurch wird vor allem gewährleistet, dass die CVD ohne Pulverbildung abläuft. Weiterhin kann die Schichtdicke während des Schichtaufwuchses in-situ gemessen und geregelt werden, wenn vorteilhaft in-situ optische Reflexionsmessungen zur Dickenbestimmung der aufgewachsenen Indiumsulfidschicht durchgeführt werden. Mittels derartiger Messungen können verschiedene Regelprozesse zur Erzielung von optimalen Indiumsulfidschichten, beispielsweise für den Einsatz als Pufferschichten in Solarzellen, beaufschlagt und in den Verfahrensablauf integriert werden.

Weitere Einzelheiten zu dem Verfahren nach der Erfindung im Batch- oder Inline-Modus sind dem nachfolgenden speziellen Beschreibungsteil zu entnehmen.

### AUSFÜHRUNGSBEISPIEL

Der Ablauf des Verfahrens nach der Erfindung wird nachfolgend zu deren weiterem Verständnis näher erläutert. Dazu zeigen die FIGUREN schematische Prinzipskizzen zur Durchführung des Verfahrens gemäß
- **FIGUR 1**: in Batch-Arbeitsweise und
- **FIGUR 2**: in Inline-Arbeitsweise

Das Verfahren nach der Erfindung gliedert sich in zwei Verfahrensphasen:

### VERFAHRENSPHASEI I

In der Verfahrensphase I werden gleichzeitig die beiden Precursor **PR_{H2S(g)}**, **PR_{In(g/fl)}** und das Inertgas **IG** zugeführt. Alle eingesetzten Komponenten überströmen das Substrat **SU** während der Verfahrensphase I. Der zweite Precursor **PR_{In(g/fl)}** kann gelöst als Aerosol (fl), oder im gasförmigen (g) Zustand zugeführt werden, der erste Precursors **PR_{H2S(g)}** wird immer in gasförmigem (g) Zustand zugeführt. Im Reaktionsgefäß **TG** wird dann der gelöste oder gasförmige zweite Precursor **PR_{In(g/fl)}** einerseits direkt auf das auf eine Temperatur gleich oder zwischen 100°C bis 275°C beheizte Substrat **SU** geleitet, andererseits gleichzeitig aber auch direkt mit dem ersten Precursor **PR_{H2S}(g)** in Form von Schwefelwasserstoffgas und dem inerten Trägergasstrom **IG** gemischt. Es ergibt sich - je nach Aggregatzustand des Precursors - ein Mischgebiet **MP** flüssig/gasförmig oder gasförmig/gasförmig. Bei der Mischung eines gelösten, zweiten Precursors **PR_{In(fl)}** mit dem gasförmigen **PR_{H2S(g)}** kann der zweite Precursor **PR_{In(fl)}** in die gelöste Phase durch Lösen in einem Lösungsmittel überführt werden. Es erfolgt dann eine Zerstäubung der Lösung mit einem Ultraschallgenerator oder pneumatischen Zerstäuber zur Erzeugung eines Sprays aus feinsten Tropfen (Aerosol) erfolgen (in der **FIGUR 1** nicht weiter dargestellt). Alternativ kann der zweite Precursor **PR_{In(g)}** auch in eine gasförmige Phase überführt werden. Dies kann erfolgen durch Überleiten eines Lösungsmitteldampfes über einen Indium enthaltenden festen (f) Precursor. Beispielsweise werden Ethanoldämpfe durch Blubbern von Inertgas, beispielsweise N₂, durch Ethanol erzeugt und dann über festes InCl₃ geleitet. Dabei bildet sich ein flüchtiges InCl₃-Ethanol-Addukt, das sich auf dem Substrat zu InCl₃ bzw. in Abhängigkeit von der Temperatur auch zu In(X(Cl), O, OH) zersetzt und abscheidet. Die Reaktion mit H₂S während der Sprühphase führt zu In(OH,X(Cl),S) Schichten, die im zweiten Verfahrensschritt zu In₂S₃ umgewandelt werden. Alternativ kann die Überführung in die gasförmige Phase auch durch Lösen in einem Lösungsmittel und Auftropfen der Lösung auf eine erwärmte Fläche erfolgen. Über die erwärmte Fläche strömt dann das Inertgas und leitet - wie vorher - den flüchtigen Precursor **PR_{In(g)}** auf das beheizte Substrat (in der **FIGUR 1** nicht weiter dargestellt).

Der zweite Precursor **PR_{In(g/fl)}** wird ungeregelt in der maximal zuführbaren Menge zugeführt. Simultan wird der erste Precursor **PR_{H2S(g)}** zugeführt. Dabei ist über das Dosierventil DV die Gaseinspeisung des gasförmigen Precursors **PR_{H2S(g)}** so eingeregelt, dass sich eine absolute Konzentration des Schwefelwasserstoffs H₂S im Mischgebiet **MP** gleich oder weniger als 1 Vol% ergibt. Durch die geregelte Einspeisung kann bereits ein kleiner Anteil der Indium-Ionen des zweiten Precursors **PR_{In(g/fl)}** mit dem Schwefel des ersten Precursors **PR_{H2S(g)}** in der Dampfphase hinter dem Mischpunkt zu den oben genannten Zwischenverbindungen und auf oder kurz oberhalb des Substrats **SU** zu Indiumsulfid In₂S₃ reagieren, so dass sich eine In(OH,X(Cl),S) Schicht bildet. Die Abscheiderate wird von der Konzentration des gasförmigen Precursors **PR_{H2S(g)}** und des zweiten Precursors **PR_{In(g/fl)}**, und von der Temperatur des Mischprecusors **MPR**, der sich im Mischgebiet **MP** oberhalb des beheizten Substrats **SU** ergibt, bestimmt.

Durch die gewählten Parameter (es herrschen Umgebungsdruck **RPR** - also Atmosphärendruck (der mittlere Luftdruck der Atmosphäre beträgt auf Meereshöhe 1013,25 mbar (Schwankungsbreite 869,9 mbar bis 1085,7 mbar) und im Reaktionsgefäß **TG** außerhalb des beheizten Substrats **SU** Umgebungstemperatur **RTE** - also Raumtemperatur, beispielsweise 18°C bis 22°C) entsteht keine vorzeitige Reaktion und damit Pulverbildung. Vielmehr wird der Mischprecursor **MPR** bis zum Substrat **SU** geführt, dessen Oberfläche auf eine Temperatur **T** zwischen 100°C und 275°C aufgeheizt worden ist. Auf dem Substrat **SU** bzw. unmittelbar darüber bildet sich somit ein Reaktionsgebiet **RP,** in dem die beiden Precursor **PR_{H2S(g)}** und **PR_{In(g/fl)}** bzw. Zwischenprodukte miteinander reagieren und zu einer Bildung der gewünschten kompakten homogenen In(OH,X(Cl),S) Schicht auf dem Substrat **SU** beitragen. Nicht abgeschiedene Reaktionsprodukte **UPR** werden hinter dem Substrat **SU** abgeführt, gesammelt und können recycelt werden.

### VERFAHRENSPHASE II

Hier wird nur der erste gasförmige Precursor **PR_{H2S(g)}** mit oder ohne Beteiligung des Trägergases **IG** zugeführt. Es findet eine intensive Ionenaustauschreaktion des Wasserstoffgases mit der zuvor auf dem Substrat **SU** abgeschiedenen In(OH,X(Cl),S)-Schicht und dem abgeschiedenen indiumhaltigen, festen Precursor **PR_{In(f)}** statt. In dieser Verfahrensphase II kann das Substrat auf eine Temperatur T gleich oder zwischen Raumtemperatur bis 450°C gehalten bzw. aufgeheizt werden, um eine optimale Durchreaktion zu ermöglichen. Eine moderate Erwärmung erhöht die Depositionsrate. Nicht umgesetzte Reaktionsprodukte **UPR** werden abgeleitet und können recycelt werden. Typischerweise folgen weitere Zyklen, bestehend aus beiden Verfahrensphasen I und II, bis die gewünschte Schichtdicke erreicht ist.

### SYNTHESEBEISPIEL FÜR DIE ABSCHEIDUNG VON INDIUMSULFID

### VERFAHRENSPHASEI I

Indiumchlorid InCl₃ ist ein Feststoff mit einem geringen Dampfdruck, d.h. sehr hohem Schmelz- bzw. Siedepunkt (586°C). Um dies Material der APCVD zugänglich zu machen, ist die Umwandlung in ein flüchtigeres Addukt z.B. mit einem Alkohol nötig. Indiumchlorid InCl₃ wird deshalb zunächst in Ethanol (alternativ in Aceton, alternativ In(acac)₃ in Ethanol) gelöst (Konzentration 25 mM), 1 ml/min dieser Lösung wird dann vernebelt. Das entstehende Aerosol wird mit einem Stickstoff-Trägergasstrom mit einer Flussrate von 5 l/min transportiert und mit einem Gasstrom von 5% H₂S in Ar, welches mit einer Injektionsrate von 15 ml/min zugeführt wird, gemischt Es ergibt sich eine absolute H₂S-Konzentration von 0,015 Vol%, welche deutlich unter 1 Vol% liegt (auch sehr geringe H₂S-Konzentration von unter 0,001 Vol% sind einsetzbar und bringen deutliche Verfahrensverbesserungen). Der Mischprecursor **MP** aus Trägergas **IG,** Aerosol (Indium enthaltender Precursor **PR_{In(g/fl)})** und Reaktivgas (gasförmiger Precursor **PR_{H2S(g)})** (und ggfs. schwefelhaltiger Zwischenprodukte) wird dann auf das geheizte Substrat **SU** geleitet, welches eine Temperatur T = 200°C aufweist. Nach 1 min wird die Verfahrensphase I gestoppt.

### VERFAHRENSPHASE II

Begasung mit H₂S (15 ml/min, Konzentration 5 Vol%, 60 s)

### WIEDERHOLUNG BEIDER VERFAHRENSPHASEN I, II

Auf dem geheizten Substrat SU bildet sich dann mit einer Aufwuchsrate von 5,4 nm/min eine kompakte Schicht aus Indiumsulfid In₂S₃ aus.

Unter gleichen Bedingungen jedoch ohne H₂S während der Verfahrensphase I (nur Sprüh-ILGAR) ergibt sich ein Schichtwachstum von nur 2,2 nm/min. Mit H₂S während der Verfahrensphase I (Erfindung) und mit einem moderaten Vorheizen des Reaktionsgefäßes bzw. der eingesetzten Komponenten bis 80°C ergibt sich ein Schichtwachstum von 15,8 nm/min.

Es sei noch angemerkt, dass die Indiumsulfidschicht auch Chlor enthält (In₂(SₓCl_{2y})₃ mit x+y=1), die sich aber auf die Qualität der hergestellten Schicht, insbesondere auch bei deren Einsatz als Pufferschicht in einer Solarzelle, nicht nachteilig auswirken.

### ANORDNUNGEN ZUR DURCHFÜHRUNG DES VERFAHRENS FÜR DIE ABSCHEIDUNG VON INDIUMSULFID

In der **FIGUR 1** ist ein Reaktionsgefäß **TG** dargestellt, das als Batch-Reaktor mit einem ortsfesten Substrat **SU** für das Verfahren nach der Erfindung bei Atmosphärendruck genutzt wird. Es werden ein erster Precursor **PR_{H2S(g)}** in Form von Schwefelwasserstoffgas H₂S und ein zweiter Precursor **PR_{In(g/fl)}**, der Indium In enthält und gasförmig oder gelöst sein kann, eingesetzt. Dabei hat der zweite Precursor **PR_{In(g/fl)}** entweder selbst einen hohen Dampfdruck oder bildet mit einem Lösungsmittel ein flüchtiges Addukt. Die Einspeisung des ersten Precursors **PR_{H2S(g)}** erfolgt über ein Dosierventil **DV** in einer ersten Zuführung **ZF1** zur gezielten Einstellbarkeit des zugeführten Schwefelwasserstoffgases. Die Einspeisung des zweiten Precursors **PR_{In(g/fl)}** erfolgt über ein Sperrventil **SV** in einer zweiten Zuführung **ZF2** zur An- oder Abschaltung der Einspeisung in vorgegebener Menge. Weiterhin wird ein Inertgasstrom **IG** zugeführt, wobei der gezeigte Einspeiseort optional ist und auch an jeder anderen geeigneten Stelle liegen kann (beispielsweise mit einem der beiden anderen Einspeiseorte **ZF** zusammenfällt). Die Einspeisung des Inertgasstromes **IG** kann bei jeder Verfahrensphase ohne ein Ventil erfolgen, wird aber vor allem zum Aerosoltransport (gelöster zweiter Precursor **PR_{In(fl)}** in versprühter Tröpfchenform) und in der Verfahrensphase I benötigt und erfolgt daher bevorzugt zusammen mit dem Aerosol über das Sperrventil **SV.**

Im Mischgebiet **MP** werden beide Precursor **PR_{H2S(g)}, PR_{In(fl)}** in der Verfahrensphase I gemischt und auf die Oberfläche des geheizten ortsfesten Substrats **SU** geleitet, auf dem in der Verfahrensphase II das Reaktionsgebiet **RP** gebildet wird. Nicht verwendete Reaktionsprodukte **URP** werden hinter dem Substrat **SU** abgeführt.

In der **FIGUR 2** ist ein Reaktionsgefäß **TG** dargestellt, das als Inline-Reaktor mit einem entlang einer Fertigungsstrecke **FS** verschiebbaren Substrat **SU** für das Verfahren nach der Erfindung bei Atmosphärendruck genutzt wird. An einer ersten Station **S1** der Fertigungsstrecke **FS** ist eine erste Zuführung **ZF1** für den ersten Precursor **PR_{H2S(g)}** mit einem Dosierventil **DV** und eine zweite Zuführung **ZF2** zumindest für den zweiten Precursor **PR_{In(g/fl)}** vorgesehen. Der Inertgasstrom **IG** kann ebenfalls über die zweite Zuführung **ZF2** zugeführt werden. Der erste Precursor **PR_{H2S(g)}** wird in einer genau dosierten Menge zugeführt, um Pulverbildung in der Gasphase zu vermeiden. Das Mischgebiet **MP** entsteht direkt oberhalb des beheizten Substrats **SU,** das auf eine Temperatur **T** gleich oder zwischen 100°C bis 275°C aufgeheizt wird. Auf dem Substrat **SU** lagert sich eine In(OH,X(Cl),S) Schicht ab.

An einer zweiten Station **S2** ist eine dritte Zuführung **ZF3** wiederum für den ersten Precursor **PR_{H2S(g)}** in Form von Schwefelwasserstoff (H₂S) vorgesehen. Ein Ventil ist hier nicht erforderlich, da H₂S in der maximal mögliche Menge zugeführt werden kann. Die zweite Station **S2** folgt der ersten Station **S1** in einem solchen Abstand nach, dass eine maximale Menge des zweiten Precursors **PR_{In(g/fl)}** an der Substratoberfläche bei Station **S1** abgelagert werden kann. In der zweiten Station **S2** kann das Substrat **SU** auf eine Temperatur **T** gleich oder zwischen Raumtemperatur und 450°C (bei Solarzellen bis 275°C) gehalten bzw. aufgeheizt werden (eine Kühlung ist ebenfalls problemlos möglich). Die abgeschiedenen Indium-Ionen reagieren nun auch mit dem Schwefelwasserstoff H₂S zu Indiumsulfid In₂S₃. Zusammen mit der Ablagerung aus der ersten Station **S1** bildet sich nunmehr eine homogene und besonders kompakte Indiumsulfidschicht In₂S₃ aus, die besonders geeignet ist als Pufferschicht in Solarzellen.

Zwischen den Stationen **S1, S2** sind Schleusen **SS** zur Gastrennung **TR** des Substrats **SU** und zur Entfernung **SP** unumgesetzter Ausgangsprodukte und unerwünschter Reaktionsprodukte **UPR** angeordnet. Diese Anordnung kann in einer Fertigungslinie zur Erzeugung vorgegebener Schichtdicken mehrfach wiederholt werden.

### BEZUGSZEICHENLISTE

- **DV**: Dosierventil
- **f**: fest
- **fl**: flüssig
- **g**: gasförmig
- **IG**: Inertgasstrom
- **MP**: Mischgebiet
- **MPR**: Mischprecusor
- **PR_{H2S(g)}**: erster Precursor (H₂S)
- **PR_{In(g/fl)}**: zweiter Precursor (In enthaltend)
- **RP**: Reaktionsgebiet (auf und unmittelbar über SU)
- **RPR**: Umgebungsdruck
- **RTE**: Umgebungstemperatur
- **S**: Station
- **SP**: Spülung
- **SS**: Schleuse
- **SU**: Substrat
- **SV**: Sperrventil
- **T**: Temperatur
- **TG**: Reaktionsgefäß
- **TR**: Gastrennung
- **UPR**: nicht abgeschiedene Reaktionsprodukte
- **X**: Halogenid
- **Z**: schwefelhaltige Verbindung
- **ZF**: Zuführung
- **x,y,z**: stöchiometrische Indices

### ZITIERTE LITERATUR

**ASIKAINEN 1994**
   T. Asikainen et al.: "Growth of In2S3 Thin Films by Atomic Layer Epitaxy" Appl. Surface Science 82/83 (1994) 122-125
**NAGHAVI 2003**
   N. Naghavi et al: "High Efficiency Copper Indium Gallium Diseienide (CIGS) Solar Cells with Indium Sulfide Buffer Layers Deposited by Atomic Layer Chemical Vapor Deposition (ALCVD)" Prog. Photovolt: Res. Appl. 2003; 11:437-443
**ALLSOP 2005**
   N.A. Allsop et al.: "Spray-ILGAR Indium Sulfide Buffers for Cu(In, Ga)(S,Se)2 Solar Cells" Prog. Photovolt: Res. Appl. 2005; 13:607-616
**ALLSOP 2006**
   N.A. Allsop et al.: "Indium Sulfide Thin Films Deposited by the Spray Ion Layer Gas Reaction Technique", Thin Solid Films 513 (2006) 52-56

## Patentansprüche

1. Verfahren zur Herstellung einer n-halbleitenden Indiumsulfid-Dünnschicht (In₂S₃) auf einem beheizten Substrat mit einem Indium enthaltenden Precursor (PR_{In(g/fl)}) und Schwefelwasserstoff (H₂S) als reaktivem, gasförmigem Precursor und einem inerten Trägergasstrom (IG) in nachstehend aufgeführten Verfahrensschritten bei Atmosphärendruck:
**VERFAHRENSPHASE I:**
• Überführung des Indium enthaltenden Precursors (PR_{In(g/fl)}, der selbst einen hohen Dampfdruck besitzt oder mit einem Lösungsmittel ein flüchtiges Addukt bildet, in eine gelöste oder gasförmige Phase,
• Sprayen des gelösten oder Leiten des gasförmigen Indium enthaltenden Precursors (PR_{In(g/fl)}) auf das auf eine Temperatur (T) gleich 100°C oder 275°C oder dazwischen beheizte Substrat (SU) und simultanes Zuführen einer solchen Menge von Schwefelwasserstoff (H₂S) zum gelösten oder gasförmigen Indium enthaltenden Precursor (PR_{In(g/fl)}), dass sich eine absolute Konzentration des Schwefelwasserstoffs (H₂S) in einem Mischgebiet (MP) ungleich Null, aber gleich oder weniger als 1 Vol% ergibt, wobei die Indium-Konzentration des Indium enthaltenden Precursors (PR_{In(g/fl)}) so gewählt wird, dass sich eine kompakte In(OHₓ,X_{y},S_{z})₃-Schicht mit X=Halogenid und x+y+2z=1 mit z ≠ 0 ausbildet,
**VERFAHRENSPHASE II:**
• Leitung des Schwefelwasserstoffs (H₂S) in einer absoluten Konzentration bis 100% auf das auf eine Temperatur (T) gleich 18°C oder 450°C oder dazwischen gehaltene oder beheizte Substrat (SU),
wobei die beiden Verfahrensphasen I und II bis zum Erreichen einer gewünschten Schichtdicke der herzustellenden Indiumsulfid-Dünnschicht zyklisch wiederholt werden.

2. Verfahren nach Anspruch 1,
**DADURCH GEKENNZEICHNET, DASS**
in der Verfahrensphase I das Substrat (SU) laminar überströmt wird.

3. Verfahren nach Anspruch 1,
**DADURCH GEKENNZEICHNET, DASS**
der Indium enthaltende Precursor (PR_{In(fl)}) in eine flüssige Phase überführt wird durch Lösen in einem Lösungsmittel und die entstehende Lösung mit einem Ultraschallgenerator oder pneumatischem Zerstäuber zur Erzeugung eines Aerosols aus feinsten Tröpfchen in Luft zerstäubt wird.

4. Verfahren nach Anspruch 1,
**DADURCH GEKENNZEICHNET, DASS**
der Indium enthaltende Precursor (PR_{In(g)}) in eine gasförmige Phase überführt wird durch Überleiten eines Lösungsmitteldampfes über den Indium enthaltenden festen Precursor PR_{In(f)}) oder durch Lösen in einem Lösungsmittel und Auftropfen der Lösung auf eine erwärmte Fläche.

5. Verfahren nach Anspruch 1,
**DADURCH GEKENNZEICHNET, DASS**
der Indium enthaltende Precursor (PR_{In(g/fl)}) ein Halogenidsalz des Indiums, vorzugsweise Indiumchlorid InCl₃, bzw. dessen Lösungsmitteladdukt ist.

6. Verfahren nach Anspruch 1,
**DADURCH GEKENNZEICHNET, DASS**
der Indium enthaltende Precursor (PR_{In(g/fl)}) ein β-Diketonat, vorzugsweise Indium-Acetylacetonat (In(acac)₃) ist.

7. Verfahren nach Anspruch 1,
**DADURCH GEKENNZEICHNET, DASS**
das Lösungsmittel ein Alkohol, vorzugsweise Ethanol, oder ein Keton, vorzugsweise Aceton, ist.

8. Verfahren nach Anspruch 1,
**DADURCH GEKENNZEICHNET, DASS**
der Trägergasstrom (IG) N₂ ist.

9. Verfahren nach Anspruch 1,
**DADURCH GEKENNZEICHNET, DASS**
das in der Umgebung des geheizten Substrats (SU) Raumtemperatur (RTE) herrscht.

10. Verfahren nach Anspruch 1,
**DADURCH GEKENNZEICHNET, DASS**
der Schwefelwasserstoff (H₂S) oder der Mischprecursor (MPR) aus dem Schwefelwasserstoff (H₂S), dem Indium enthaltenden Precursor (PR_{In(fl)}) und dem Trägergasstrom (IG) vorgeheizt wird.

11. Verfahren nach Anspruch 1,
**DADURCH GEKENNZEICHNET, DASS**
als Substrat (SU) Ti0₂, CuInS₂, CuGaSe₂, Chalkopyrite, Metalle oder Glas eingesetzt werden.

12. Verfahren nach Anspruch 1,
**DADURCH GEKENNZEICHNET, DASS**
in-situ optische Konzentrationsmessungen von eingesetzten Aerosolen zur Konzentrationsbestimmung der anteiligen Komponenten durchgeführt werden.

13. Verfahren nach Anspruch 1,
**DADURCH GEKENNZEICHNET, DASS**
in-situ optische Reflexionsmessungen zur Dickenbestimmung der aufgewachsenen Indiumsulfid-Dünnschicht (In₂S₃) durchgeführt werden.

## Claims

1. A method for producing an n-type semiconductive indium sulfide thin film (In₂S₃) on a heated substrate using an indium-containing precursor (PR_{in(g/fl)}) and hydrogen sulfide (H₂S) as a reactive gaseous precursor, and an inert carrier gas stream (IG), the method being carried out at atmospheric pressure by means of the following method steps:
**METHOD PHASE I:**
• converting the indium-containing precursor (PR_{In(g/fl)}), which itself has a high vapour pressure or with a solvent forms a volatile adduct, into a dissolved or gaseous phase,
• spraying the dissolved or conveying the gaseous indium-containing precursor (PR_{in(g/fl)}) onto the substrate (SU) heated to a temperature (T) equal to 100 °C or 275 °C or therebetween and simultaneously feeding such a quantity of hydrogen sulfide (H₂S) to the dissolved or gaseous indium-containing precursor (PR_{in(g/fl)}) that an absolute concentration of the hydrogen sulfide (H₂S) in a mixed area (MP) unequal to zero, but equal to or less than 1 vol. % is produced, wherein the indium concentration of the indium-containing precursor (PR_{in(g/fl)}) is selected such that a compact In(OHₓ, X_{y}, S_{z})₃ layer with X=halogenide and x+y+2z=1 with z≠0 is formed,
**METHOD PHASE II:**
• conveying the hydrogen sulfide (H₂S) in an absolute concentration up to 100 % to the substrate (SU) heated to or held at a temperature (T) equal to 18 °C or 450 °C or therebetween,
wherein the two method phases I and II are repeated cyclically until reaching a desired layer thickness of the indium sulfide thin film to be produced.

2. The method according to Claim 1,
**CHARACTERISED IN THAT**
the substrate (SU) is subject to a laminar flow in method phase I.

3. The method according to Claim 1,
**CHARACTERISED IN THAT**
the indium-containing precursor (PR_{in(g/fl)}) is converted into a liquid phase by dissolution in a solvent, and the produced solution is atomised with an ultrasound generator or pneumatic atomiser in order to generate an aerosol formed form very fine droplets in air.

4. The method according to Claim 1,
**CHARACTERISED IN THAT**
the indium-containing precursor (PR_{in(g/fl)}) is converted into a gaseous phase by conveying a solvent vapour over the indium-containing solid precursor (PR_{in(g/fl)}) or by dissolution in a solvent and applying the solution in drops to a heated surface.

5. The method according to Claim 1,
**CHARACTERISED IN THAT**
the indium-containing precursor (PR_{in(g/fl)}) is a halogenide salt of indium, preferably indium chloride InCl₃, or a solvent adduct thereof.

6. The method according to Claim 1,
**CHARACTERISED IN THAT**
the indium-containing precursor (PR_{in(g/fl)}) is a β-diketonate, preferably indium acetylacetonate (In(acac)₃).

7. The method according to Claim 1,
**CHARACTERISED IN THAT**
the solvent is an alcohol, preferably ethanol, or a ketone, preferably acetone.

8. The method according to Claim 1,
**CHARACTERISED IN THAT**
the carrier gas stream is (IG)N₂.

9. The method according to Claim 1,
**CHARACTERISED IN THAT**
room temperature (RTE) prevails in the surrounding environment of the heated substrate (SU).

10. The method according to Claim 1,
**CHARACTERISED IN THAT**
the hydrogen sulfide (H₂S) or the mix precursor (MPR) formed from the hydrogen sulfide (H₂S), the indium-containing precursor (PR_{in(g/fl)}) and the carrier gas stream (IG) is preheated.

11. The method according to Claim 1,
**CHARACTERISED IN THAT**
TiO₂, CuInS₂, CuGaSe₂, chalcopyrites, metals or glass are used as substrate (SU).

12. The method according to Claim 1,
**CHARACTERISED IN THAT**
*in situ* optical concentration measurements of used aerosols are carried out in order to determine the concentration of the individual components.

13. The method according to Claim 1,
**CHARACTERISED IN THAT**
*in situ* optical reflection measurements are carried out in order to determine the thickness of the grown indium sulfide thin film (In₂S₃).

## Revendications

1. Procédé de production d'une couche mince n semi-conductrice de sulfure d'indium (In₂S₃) sur un substrat chauffé avec un précurseur (PR_{In(g/fl)}) contenant de l'indium et de l'acide sulfhydrique (H₂S) en tant que précurseur gazeux réactif et un flux inerte de gaz porteur (IG) dans les étapes de procédé mentionnées ci-dessous, sous pression atmosphérique :
**PHASE I DU PROCEDE :**
• Transformer le précurseur (PR_{In(g/fl)}) contenant de l'indium, qui détient lui-même une pression de vapeur élevée ou qui avec un solvant forme un produit d'addition volatil en une phase dissoute ou gazeuse,
• Vaporiser le précurseur (PR_{In(g/fl)}) dissous contenant de l'indium ou diriger celui sous forme gazeuse sur le substrat (SU) chauffé dans l'intervalle à une température (T) égale à 100°ou à 275° et amener simultanément vers le précurseur (PR_{In(g/fl)}) dissous ou gazeux contenant de l'indium une quantité telle d'acide sulfhydrique (H₂S) qu'il en résulte une concentration absolue de l'acide sulfhydrique (H₂S) dans un ordre de mélange (MP) non égal à zéro mais inférieur ou égal à 1 % en volume, la concentration en indium du précurseur (PR_{In(g/fl)}) contenant de l'indium étant choisie de sorte qu'il se forme une couche compacte In(OHₓ, X_{y}, S_{z})₃, avec H = halogénure et x+y+2z=1, avec z≠ 0.
**PHASE II DU PROCEDE :**
• Diriger l'acide sulfhydrique (H₂S) dans une concentration absolue de jusqu'à 100 % sur le substrat (SU) maintenu ou chauffé dans l'intervalle à une température (T) égale à 18 °C ou à 450 °C,
en répétant cycliquement les deux phases I et II du procédé jusqu'à l'obtention d'une épaisseur de couche souhaitée pour la couche mince de sulfure d'indium.

2. Procédé selon la revendication 1, **caractérisé en ce que** dans la phase I du procédé, on submerge de façon laminaire le substrat (SU).

3. Procédé selon la revendication 1, **caractérisé en ce qu'**on transforme le précurseur (PR_{In(g/fl)}) contenant de l'indium en une phase liquide en le diluant dans un solvant et on pulvérise la solution obtenue avec un générateur d'ultrasons ou un pulvérisateur pneumatique pour créer un aérosol de gouttelettes ultra-fines dans l'air.

4. Procédé selon la revendication 1, **caractérisé en ce qu'**on transforme le précurseur (PR_{In(g/fl)}) contenant de l'indium en une phase gazeuse, en faisant passer une vapeur de solvant sur le précurseur (PR_{In(g/fl)}) solide contenant de l'indium ou en le diluant dans un solvant et on l'applique au goutte à goutte sur une surface chauffée.

5. Procédé selon la revendication 1, **caractérisé en ce que** le précurseur (PR_{In(g/fl)}) contenant de l'indium est un sel d'halogénure de l'indium, de préférence du chlorure d'indium InCl₃ ou son produit d'addition en solvant.

6. Procédé selon la revendication 1, **caractérisé en ce que** le précurseur (PR_{In(g/fl)}) contenant de l'indium est un β-dicétonate, de préférence de l'acétylacétonate d'indium (In(acac)₃).

7. Procédé selon la revendication 1, **caractérisé en ce que** le solvant est un alcool, de préférence de l'éthanol ou une cétone, de préférence de l'acétone.

8. Procédé selon la revendication 1, **caractérisé en ce que** le flux de gaz porteur (IG) est du N₂.

9. Procédé selon la revendication 1, **caractérisé en ce que** dans l'environnement du substrat (SU) chauffé, il règne une température ambiante (RTE).

10. Procédé selon la revendication 1, **caractérisé en ce qu'**on préchauffe l'acide sulfhydrique (H₂S) ou le précurseur de mélange (MPR) de l'acide sulfhydrique (H₂S), du précurseur (PR_{In(g/fl)}) contenant de l'indium et du flux de gaz porteur (IG).

11. Procédé selon la revendication 1, **caractérisé en ce qu'**on utilise en tant que substrat (SU) du Ti02, du CUInS₂, du CuGaSe₂, des chalcopyrites, des métaux ou du verre.

12. Procédé selon la revendication 1, **caractérisé en ce qu'**on procède à des mesures optiques de concentration in-situ d'aérosols mis en oeuvre pour définir la concentration des composants proportionnels.

13. Procédé selon la revendication 1, **caractérisé en ce qu'**on procède à des mesures optiques de réflexion in-situ pour définir l'épaisseur de la couche mince de sulfure d'indium (In₂S₃) formée.
